# EUROPEAN PATENT APPLICATION

(11) **EP 2 077 584 A2**
(43) Date of publication of application: **08.07.2009**
(21) Application number: 08250991.0
(22) Date of filing: 20.03.2008
(51) Int. Cl.: H01L 31/0216

(54) **Passivation layer structure of solar cell and fabricating method thereof**

(30) Priority: 28.12.2007 TW 96151035
(71) Applicant: Industrial Technology Research Institute, Chutung Hsinchu 31040 (TW)
(72) Inventor: Sun, Wen-Ching, Pingjhen City, Taoyuan County 324 (TW); Chen, Chien-Hsun, East District, Tainan City 701 (TW); Lan, Chung-Wen, Dindian City, Taipei County 231 (TW); Huang, Chien-Rong, East District, Hsinchu City 300 (TW)
(74) Representative: Johnson, Terence Leslie

(57) **Abstract**

A passivation layer structure of a solar cell, disposed on a substrate (10), is provided. The passivation layer structure has a first passivation layer (20) and a second passivation layer (30). The first passivation layer (20) is disposed on the substrate (10). The second passivation layer (30) is disposed between the substrate (10) and the first passivation layer (20), and the material of the second passivation layer (30) is an oxide of the material of the substrate (10). Since the second passivation layer (30) is disposed between the substrate (10) and the first passivation layer (20), the surface passivation effect and carrier lifetime of a photoelectric device are enhanced, and a photoelectric conversion efficiency of the solar cell is increased as well.

## Description

### BACKGROUND OF THE INVENTION

### 1. Field of the Invention

The present invention generally relates to a photoelectric device, in particular, to a passivation layer structure of a solar cell, and a fabricating method thereof.

### 2. Description of Related Art

Solar energy is an inexhaustible energy having no pollution. As the petrochemical energy source encounters the pollution and energy shortage problems, the solar energy attracts most of the attentions. Recently, it becomes a quite important research issue to directly convert a solar cell into electric energy.

Silicon-based solar cell is a common solar cell in the industry. The working principle of the silicon-base solar cell is that some impurities are added into a semiconductor material (silicon) with high purity, such that the semiconductor material has different features, so as to form a p-type semiconductor and an n-type semiconductor, and to joint the p-type and n-type semiconductors, thereby forming a p-n junction. The p-n junction is formed by positive donor ions and negative acceptor ions, and a built-in potential exists in a region where the positive and negative ions are located. The built-in potential may drive away movable carriers in the region, so that the region is called a depletion region. When the sunlight is irradiated onto a semiconductor with a p-n structure, the energy provided by photons excites electrons in the semiconductor, so as to generate electron-hole pairs. The electrons and holes are both affected by the built-in potential, the holes move towards a direction of the electric field, whereas the electrons move towards an opposite direction. If the solar cell is connected to a load through a wire to form a loop, the current flows through the load, which is the principle for the solar cell to generate electricity. If it intends to modify the solar cell, it is better to begin from improving the photoelectric conversion efficiency.

Generally, besides an anti-reflection layer, a passivation layer is a factor for determining the efficiency of a solar cell. A desirable passivation layer may form dangling bonds on a silicon surface or a defective position (e.g., dislocation, grain boundary, or point defect), so as to effectively reduce the recombination rate of the electron-hole pairs on the silicon surface and defective position, thereby improving the lifetime of a few carriers and improving the efficiency of the solar cell. The efficiency of the solar cell can be improved, if it is possible to improve the passivation effect of the passivation layer.

### SUMMARY OF THE INVENTION

Accordingly, the present invention seeks to provide a passivation layer structure of a solar cell, which is capable of improving the surface passivation effect and directly improving the photoelectric conversion efficiency of the solar cell.

In view of the above mentioned, the present invention provides a passivation layer structure of a solar cell, disposed on a photoelectric conversion layer. The passivation layer structure includes a first passivation layer and a second passivation layer. The first passivation layer is disposed on the photoelectric conversion layer. The second passivation layer is disposed between the photoelectric conversion layer and the first passivation layer, and a material of the second passivation layer is an oxide of a material of the photoelectric conversion layer.

The present invention provides a method of fabricating a passivation layer structure of a solar cell, which includes the following steps. Firstly, a photoelectric conversion layer is provided. Next, a second passivation layer is formed on the photoelectric conversion layer, and a first passivation layer is formed on the second passivation layer. The material of the second passivation layer is an oxide of the material of the photoelectric conversion layer.

In the structure of the present invention, the second passivation layer is disposed between the substrate and the first passivation layer, so as to enhance the passivation effect of the passivation layer, thereby greatly increasing the photoelectric conversion efficiency of the solar cell.

### BRIEF DESCRIPTION OF THE DRAWINGS

The accompanying drawings are included to provide a further understanding of embodiments of the invention, and are incorporated in and constitute a part of this specification purely by way of example. The drawings illustrate embodiments of the invention and, together with the description, serve to explain the principles of embodiments of the invention.

FIG. 1 is a cross-sectional view of a passivation layer structure of a solar cell according to an embodiment of the present invention.

FIG. 2 is a cross-sectional view of a solar cell according to an embodiment of the present invention.

### DESCRIPTION OF THE EMBODIMENTS

Reference will now be made in detail to the present embodiments of the invention, examples of which are illustrated in the accompanying drawings. Wherever possible, the same reference numbers are used in the drawings and the description to refer to the same or like parts.

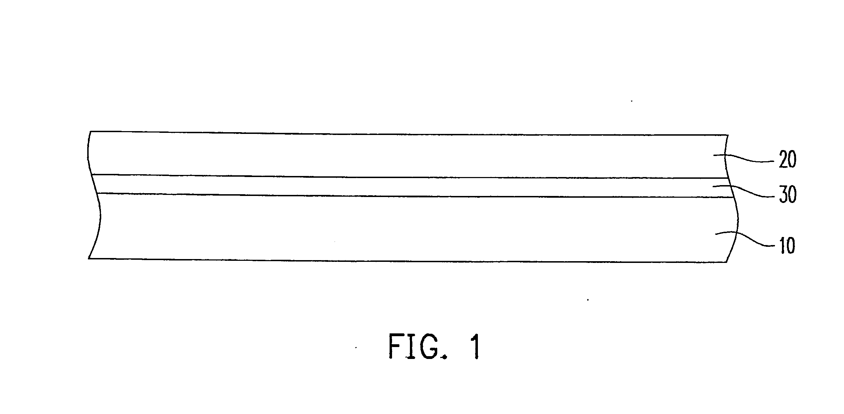

FIG. 1 is a cross-sectional view of a passivation layer structure of a solar cell according to an embodiment of the present invention.

Referring to FIG. 1, a passivation layer structure of a solar cell of the present invention is disposed on a substrate 10, and has a first passivation layer 20 and a second passivation layer 30. The first passivation layer 20 is disposed on the substrate 10. The second passivation layer 30 is disposed between the substrate 10 and the first passivation layer 20, and the material of the second passivation layer 30 is different from that of the first passivation layer 20. The substrate 10 is, for example, a photoelectric conversion layer of the solar cell.

The first passivation layer 20 has a thickness of, for example, 2 nm to 100 nm. The first passivation layer 20 is made of, for example, aluminium oxide, zinc oxide, or indium tin oxide. The process for forming the first passivation layer 20 is, for example, one selected from a group consisting of atomic layer deposition (ALD), sputtering, plasma enhanced chemical vapor deposition (PECVD), and molecular beam epitaxy (MBE).

The second passivation layer 30 is, for example, disposed between the substrate 10 and the first passivation layer 20. The material of the second passivation layer 30 is, for example, an oxide of the material of the substrate 10. For example, if the material of the substrate 10 is silicon, the material of the second passivation layer 30 is silicon oxide. The second passivation layer 30 has a thickness of, for example, 1 nm to 15 nm. A process for forming the second passivation layer 30 is, for example, thermal oxidation process.

In the passivation layer structure of the solar cell and the fabricating method thereof of the present invention, the second passivation layer 30 is disposed between the substrate 10 and the first passivation layer 20, so as to effectively enhance the surface passivation effect and the carrier lifetime.

The structure for improving the surface passivation effect and the fabricating method thereof in the present invention have been illustrated above. Then, it is illustrated below of applying the structure for improving the surface passivation effect in the present invention to the solar cell in an embodiment of the present invention.

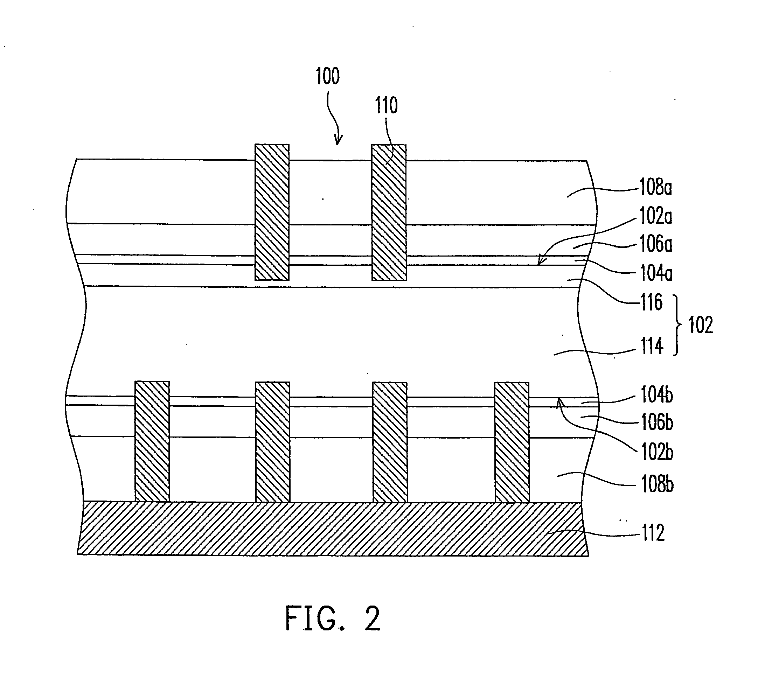

FIG. 2 is a cross-sectional view of a solar cell according to an embodiment of the present invention.

Referring to FIG. 2, the solar cell 100 is, for example, formed by a photoelectric conversion layer 102, a second passivation layer 104a, a second passivation layer 104b, a first passivation layer 106a, a first passivation layer 106b, an anti-reflection layer 108a, an anti-reflection layer 108b, a first electrode 110, and a second electrode 112.

The photoelectric conversion layer 102 is made of, for example, silicon and an alloy thereof, CdS, CuInGaSe₂ (CIGS), CuInSe₂ (CIS), CdTe, an organic material, or a multi-layer structure stacked by the above materials. The silicon includes single crystal silicon, polysilicon, and amorphous silicon. The silicon alloy refers to adding H atom, F atom, Cl atom, Ge atom, O atom, C atom, N atom, or another atom into the silicon.

In this embodiment, a silicon-based solar cell is taken as an example for the solar cell 100. The photoelectric conversion layer 102 is, for example, formed by a P-type semiconductor layer 114 and an N-type semiconductor layer 116. The P-type semiconductor layer 114 is doped with elements of Group III in the periodic table, for example, B, Ga, and In. The N-type semiconductor layer 116 is doped with elements of Group V in the periodic table, for example, P, As, and Sb. The P-type semiconductor layer 114 and the N-type semiconductor layer 116 are contacted to form a PN junction. The photoelectric conversion layer 102 has a first surface 102a and a second surface 102b, in which the first surface 102a is opposite to the second surface 102b.

The first passivation layer 106a and the first passivation layer 106b are, for example, respectively disposed on the first surface 102a and the second surface 102b of the photoelectric conversion layer 102. The first passivation layer 106a and the first passivation layer 106b have a thickness of, for example, 2 nm to 100 nm. The first passivation layer 106a and the first passivation layer 106b are made of a metal oxide with fixed negative charges. The first passivation layer 106a and the first passivation layer 106b are made of, for example, silicon oxide, aluminium oxide, zinc oxide, or indium tin oxide.

The second passivation layer 104a and the second passivation layer 104a are, for example, respectively disposed on the first surface 102a and the second surface 102b of the photoelectric conversion layer 102, and they are respectively located between the photoelectric conversion layer 102 and the first passivation layer 106a and between the photoelectric conversion layer 102 and the first passivation layer 106b. The material of the second passivation layer 104a and the second passivation layer 104b is different from that of the first passivation layer 106. The material of the second passivation layer 104a and the second passivation layer 104b is, for example, an oxide of the material of the photoelectric conversion layer 102. The second passivation layer 104a and the second passivation layer 104b are made of, for example, silicon oxide. The second passivation layer 104 has a thickness of, for example, 1 nm to 15 nm.

The anti-reflection layer 108a and the anti-reflection layer 108b are, for example, respectively disposed on the first passivation layer 106a and the first passivation layer 106b. The anti-reflection layer 108a and the anti-reflection layer 108b are made of, for example, silicon oxynitride and silicon nitride, etc.

The first electrode 110 is, for example, disposed on the first surface 102a of the photoelectric conversion layer 102. The first electrode 108, for example, passes through the anti-reflection layer 108a, the first passivation layer 106a, and the second passivation layer 104a to be electrically connected to the photoelectric conversion layer 102.

The second electrode 112 is, for example, disposed on the second surface 102b of the photoelectric conversion layer 102. The second electrode 112, for example, covers the second surface 102b of the photoelectric conversion layer 102, and passes through the anti-reflection layer 108b, the first passivation layer 106b, and the second passivation layer 104b to be electrically connected to the photoelectric conversion layer 102. The first electrode 110 and the second electrode 112 are made of a metal material (e.g., aluminium) or transparent conductive oxide (TCO). The process for forming the first electrode 110 and the second electrode 112 is, for example, a CVD method, sputtering method, screen print and firing method, or other appropriate processes.

In this embodiment, the second passivation layer 104a (104b) is disposed between the photoelectric conversion layer 102 and the first passivation layer 106a (1 06b), so as to effectively enhance the surface passivation effect and the carrier lifetime, and to greatly improve the efficiency of the solar cell. Definitely, in other embodiments, a stacking structure of the first passivation layer and the second passivation layer may be merely formed on one of the first surface 102a and the second surface 102b of the photoelectric conversion layer 102.

The present invention is illustrated below by the following experimental examples.

[Experiment on Carrier Lifetime]

Two Czochralski (CZ) silicon wafers with similar carrier lifetime are prepared for the research of the second passivation layer.

Experimental Example 1

A layer of silicon oxide with a thickness of 2 nm is grown on a silicon wafer to serve as a second passivation layer, and then a layer of aluminium oxide with a thickness of 15 nm is coated by an ALD process to serve as a first passivation layer.

Comparative Example 1

A layer of aluminium oxide with a thickness of 15 nm is coated on the silicon wafer by the ALD process to serve as a first passivation layer.

Then, the carrier lifetime measurement is respectively performed on the samples of the Experimental Example 1 and the Comparative Example 1 before and after the treatment of a nitrogen and hydrogen mixing atmosphere (forming gas), and the results are listed in Table 1.

**Table 1**

| | Silicon Wafer | Before the Treatment of Forming Gas | After the Treatment of Forming Gas |
|---|---|---|---|
| Comparative Example 1 | 3.7202 (µs) | 18.4351 (µs) | 29.8546 (µs) |
| Experimental Example 1 | 3.4987 (µs) | 52.405 (µs) | 102.89 (µs) |

Base on the results of Table 1, no matter before or after the treatment of the nitrogen and hydrogen forming gas, the carrier lifetime in the Experimental Example 1 is longer than that in the Comparative Example 1. After the treatment of the nitrogen and hydrogen forming gas, the carrier lifetime in the Experimental Example even exceeds 100 µs. The experiment proves that, better surface passivation effect can be achieved by disposing the second passivation layer.

[Experiment on Solar Cell Characteristics]

Three poly-silicon wafers with similar carrier lifetime are prepared, and they are respectively fabricated to the solar cell according to the following conditions, and relevant solar cell characteristics are measured, so as to perform the research of the second passivation layer.

Experimental Example 2

The photoelectric conversion layer of the solar cell is formed by p-type poly-silicon wafer (mc-Si wafer) of 1*10²⁰ cm⁻³ doped with B. The mean grain size of the poly-silicon wafer is approximately 5 mm. A pyramid structure is pre-fabricated on a surface of the wafer. The NP junction is finished by performing diffusion for 20 minutes at 850°C by using phosphorus oxychloride (POCl₃). Then, the passivation layer is respectively formed on the front and back surfaces of the wafer. The passivation layer is formed by a second passivation layer and a first passivation layer, and the forming process thereof includes: firstly, a layer of silicon oxide with a thickness of 2 nm is grown on the front and back surfaces of the poly-silicon wafer to serve as the second passivation layer, and then a layer of aluminium oxide with a thickness of 15 nm is coated by the ALD process to serve as the first passivation layer. An anti-reflection layer is respectively formed on the front and back surfaces of the wafer, which is formed by an a-SiNx:H film of approximately 90 nm. The anti-reflection layer is formed by performing a deposition process at a reaction temperature of 350°C by using a RF capacitively coupled plasma (CCP), and taking SiH₄ and NH₃ as precursors. Then, the metal electrode is fabricated on the front and back surfaces of the poly-silicon wafer. The metal electrode on the front surface is an aluminium electrode fabricated by the metal printing and then by a sintering process at the temperature of 930°C; and the electrode on the back surface is an aluminium electrode grown by a sputtering method and then processed by the laser sintering.

Comparative Example 2

The process is the same as the Experimental Example, except that only one layer of silicon oxide with a thickness of 20 nm formed by the thermal oxidation process is taken as the passivation layer.

Comparative Example 3

The process is the same as the Experimental Example, except that only one layer of aluminium oxide with a thickness of 15 nm formed by the ALD process is taken as the passivation layer, and the results are shown in Table 2.

**Table 2**

| | Short Circuit Current Isc (mA) | Short Circuit Current Density Jsc (mA/cm²) | Open Circuit Voltage Voc (V) | Filling Factor F.F. (%) | Photoelectric Conversion Efficiencyη (%) |
|---|---|---|---|---|---|
| Experimental Example 2 | 0.271 | 37.958 | 0.619 | 81.27 | 19.09 |
| Comparative Example 3 | 0.253 | 35.364 | 0.613 | 80.24 | 17.41 |
| Comparative Example 4 | 0.243 | 34.076 | 0.607 | 79.01 | 16.33 |

According to the results of Table 2, the photoelectric conversion efficiency of the Experimental Example 2 is higher than that of the Comparative Examples 2 and 3, and the experiment proves that, better surface passivation effect can be obtained by disposing the second passivation layer.

A sintering process is required when the first passivation layer is used for fabricating the solar cell electrode in the conventional art. After the high temperature sintering process, the first passivation layer may generate crystallization, and the lattice constant of the first passivation layer with negative charges is generally different from that of the semiconductor material. There are dislocations when the two materials with different lattice constants are jointed together. However, in the present invention, a thinner second passivation layer is disposed between the photoelectric conversion layer and the first passivation layer, not only the defects generated on the interface during the crystallization of the first passivation layer are reduced, but the first passivation layer with negative charges can also effectively enhance the surface passivation effect and the carrier lifetime, thereby greatly improving the photoelectric conversion efficiency of the solar cell.

To sum up, in the passivation layer structure of the solar cell and the fabricating method thereof of the present invention, the second passivation layer is disposed between the photoelectric conversion layer and the first passivation layer, so as to effectively enhance the surface passivation effect and the carrier lifetime, thereby greatly improving the photoelectric conversion efficiency of the solar cell.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims and their equivalents.

## Claims

1. A passivation layer structure of a solar cell, disposed on a photoelectric conversion layer, the passivation layer structure comprising:
a first passivation layer, disposed on the photoelectric conversion layer; and
a second passivation layer, disposed between the photoelectric conversion layer and the first passivation layer, wherein a material of the second passivation layer is an oxide of a material of the photoelectric conversion layer.

2. A passivation layer structure of a solar cell according to claim 1, wherein a thickness of the first passivation layer is 2 nm to 100 nm.

3. A passivation layer structure of a solar cell according to claim 1 or 2, wherein a material of the first passivation layer is a metal oxide with fixed negative charges.

4. A passivation layer structure of a solar cell according to any preceding claim, wherein the material of the first passivation layer is one selected from a group consisting of aluminium oxide, zinc oxide, and indium tin oxide.

5. A passivation layer structure of a solar cell according to any preceding claim, wherein a thickness of the second passivation layer is 1 nm to 15 nm.

6. A passivation layer structure of a solar cell according to any preceding claim, wherein the material of the second passivation layer is silicon oxide.

7. A passivation layer structure of a solar cell according to any preceding claim, wherein the material of the second passivation layer is silicon oxide, and the material of the first passivation layer is aluminium oxide.

8. A passivation layer structure of a solar cell according to any preceding claim, wherein the material of the first passivation layer is an aluminium layer formed by an atomic layer deposition (ALD).

9. A method of fabricating a passivation layer structure of a solar cell, comprising:
providing a photoelectric conversion layer;
forming a second passivation layer on the photoelectric conversion layer, wherein a material of the second passivation layer is an oxide of a material of the photoelectric conversion layer; and
forming a first passivation layer on the second passivation layer.

10. A method of fabricating a passivation layer structure of a solar cell according to claim 9, wherein a process of forming the first passivation layer is one selected from a group consisting of an ALD, plasma enhanced chemical vapor deposition (PECVD), sputtering method, and molecular beam epitaxy (MBE).

11. A method of fabricating a passivation layer structure of a solar cell according to claim 9 or 10, wherein a thickness of the first passivation layer is 2 nm to 100 nm.

12. A method of fabricating a passivation layer structure of a solar cell according to claim 9, wherein a material of the first passivation layer is a metal oxide with fixed negative charges.

13. A method of fabricating a passivation layer structure of a solar cell according to any one of claims 9 to 12, wherein the material of the first passivation layer is one selected from a group consisting of aluminium oxide, zinc oxide, and indium tin oxide.

14. A method of fabricating a passivation layer structure of a solar cell according to any one of claims 9 to 13, wherein a process of forming the second passivation layer is to perform a thermal oxidation process.

15. A method of fabricating a passivation layer structure of a solar cell according to any one of claims 9 to 14, wherein a thickness of the second passivation layer is 1 nm to 15 nm.

16. A method of fabricating a passivation layer structure of a solar cell according to any one of claims 9 to 15, wherein the material of the second passivation layer is silicon oxide.

17. A method of fabricating a passivation layer structure of a solar cell according to any one of claims 9 to 16, wherein the material of the first passivation layer is aluminium oxide formed by the ALD, and the material of the second passivation layer is silicon oxide.
